# EUROPÄISCHE PATENTANMELDUNG

(11) **EP 1 533 818 A1**
(43) Veröffentlichungstag der Anmeldung: **25.05.2005**
(21) Anmeldenummer: 03026229.9
(22) Anmeldetag: 14.11.2003
(51) Int. Cl.: H01G 9/00

(54) **Photoelektrochemische Solarzelle**

(71) Anmelder: COMA Beteiligungsgesellschaft mbH, 47809 Krefeld (DE)
(72) Erfinder: Kolbusch, Thomas, 47809 Krefeld (DE); Giessmann, Andreas, Dr., 41464 Neuss (DE); Khouri, Bruce M., Glendale, CA 91207 (US); Stevenson, Edward. J., Malibu, CA 90265 (US)
(74) Vertreter: Stenger, Watzke & Ring Patentanwälte

(57) **Zusammenfassung**

Um eine Solarzelle zu bilden, die bei gleichzeitig erhöhtem Wirkungsgrad eine verbesserte Langzeitstabilität aufweist, wird mit der Erfindung vorgeschlagen eine photoelektrochemische Solarzelle, aufweisend eine erste elektronenleitende Schicht (5) und eine zweite elektronenleitende Schicht (2), eine zwischen der ersten und der zweiten elektronenleitenden Schicht (2, 5) angeordnete photoempfindliche Schicht (4) sowie eine zwischen photoempfindlicher und zweiter elektronenleitenden Schicht (4, 2) angeordnete elektrolytische Schicht (3), wobei die elektrolytische Schicht (3) durch einen Festkörperelektrolyten gebildet ist.

## Beschreibung

Die Erfindung betrifft eine photoelektrochemische Solarzelle sowie ein photoelektrochemisches Modul.

Photoelektrochemische Solarzellen sind aus dem Stand der Technik an sich bekannt. Insbesondere Silicium-Solarzellen haben in den letzten Jahren weite Verbreitung gefunden.

Herkömmliche Solarzellen bestehen aus mindestens zwei Schichten eines Halbleitermaterials, wie zum Beispiel Silicium, in dem elektronische Ladungen durch die Energie des einfallenden Sonnenlichtes freigesetzt werden. Eine dieser Schichten, der sogenannte p-Halbleiter, weist positive elektrische Charakteristiken auf, die andere Schicht hingegen, der sogenannte n-Halbleiter, negative.

Treffen nun Lichtquanten auf die Solarzelle, so absorbieren die Atome des Halbleiters Photonen. Dadurch werden in der p-Schicht Elektronen freigesetzt und fließen zur n-Schicht. Dieser Elektronenfluß ist ein elektrischer Strom, der durch entsprechende Einrichtungen abgegriffen und nutzbar gemacht werden kann.

Die Energieausbeute einer Solarzelle ist abhängig vom Standort der Solarzelle, der Sonnenscheindauer, dem Einstrahlungswinkel bzw. dem Aufstellungswinkel der Solarzelle sowie vom Wirkungsgrad der Solarzelle, wobei herkömmliche Solarzellen über einen Wirkungsgrad von ca. 10 bis 15 % verfügen.

Auch sind aus dem Stand der Technik Solarzellen bekannt, bei denen zwischen einem transparenten n-Halbleiter und einem transparenten p-Halbleiter eine ebenfalls transparent ausgebildete photochemisch aktive Schicht angeordnet ist, die zum Zwecke der Lichtsabsorption mit Sensibilisatorfarbstoffen angereichert ist. Eine auf die Solarzelle auftreffende elektromagnetische Strahlung wird mittels der Sensibilisatorfarbstoffe der photochemisch aktiven Schicht absorbiert, infolge dessen Ladungsträger in Form von Elektronen freigesetzt werden. Um ein zyklisches System zu erhalten, muß der Sensibilisatorfarbstoff wieder regeneriert werden. Dies geschieht über ein Redoxpaar, das über eine Gegenelektrode, die zuvor übertragenen Elektronen wieder aufnimmt und damit den Kreislauf schließt. Die Verwendung von Sensibilisatorfarbstoffen ist jedoch nicht frei von Nachteilen. So weisen Sensibilisatorfarbstoffe auf organischer Basis eine zu geringe Langzeitstabilität auf. Abhilfe kann hier die Verwendung von Rutheniumkomplexen schaffen, doch ist deren Einsatz in nachteiliger Weise wirtschaftlich sehr aufwendig.

Zur Steigerung des Wirkungsgrades einer Solarzelle ist es aus dem Stand der Technik darüber hinaus bekannt, zwischen der photochemisch aktiven Schicht einerseits und dem p-Halbleiter andererseits eine elektrolytische Schicht anzuordnen. Gebildet ist die elektrolytische Schicht aus einem flüssigen Elektrolyten, der unter Verwendung eines geeigneten Dichtungsmaterials gegenüber den anderen Schichten der Solarzelle abgedichtet ist. Obgleich infolge der Zwischenordnung einer elektrolytischen Schicht der Wirkungsgrad der Solarzelle erhöht werden kann, hat sich der Einsatz einer derartigen Solarzelle in der Praxis nicht bewährt, denn ist die Ausbildung einer Elektrolytabdichtung sehr aufwendig und damit in nachteiliger Weise kostenintensiv. Begründet ist dies damit, daß die Dichtungsmaterialien nicht nur steigenden Temperaturänderungen und Sonnenlichtexplosionen widerstehen müssen, auch müssen sie gegen die hochgradig agressive Elektrolytflüssigkeit dauerhaft beständig sein. In der Vergangenheit ist es wiederholt zu Dichtigkeitsproblemen gekommen, was in nachteiliger Weise den Ausfall der gesamten Solarzelle zur Folge hatte.

Ausgehend vom vorgenannten Stand der Technik ist es **Aufgabe** der Erfindung, eine Solarzelle bereitzustellen, die bei einem gleichzeitig verbesserten Wirkungsgrad über eine vergrößerte Langzeitstabilität verfügt.

Zur **Lösung** dieser Aufgabe wird mit der Erfindung vorgeschlagen eine photoelektrochemische Solarzelle, aufweisend eine erste elektronenleitende Schicht und eine zweite elektronenleitende Schicht, eine zwischen der ersten und der zweiten elektronenleitenden Schicht angeordnete photoempfindliche Schicht sowie eine zwischen photoempfindlicher und zweiter elektronenleitenden Schicht angeordnete elektrolytische Schicht, wobei die elektrolytische Schicht durch einen Festkörperelektrolyten gebildet ist.

Die erfindungsgemäße Solarzelle verfügt mit Vorteil über zwei in unterschiedlichen Wellenlängenbereichen reagierende Absorptionsschichten, wobei als erste Absorptionsschicht eine photoempfindliche Schicht und als zweite Absorptionsschicht eine elektrolytische Schicht vorgesehen sind. Die Anordnung dieser beiden Absorptionsschichten erhöht deutlich den Wirkungsgrad der gesamten Solarzelle, denn kann ein Wirkungsgrad von bis zu ca. 30 % erreicht werden. Zudem besteht ein wesentlicher Vorteil im Vergleich zu herkömmlichen Solarzellen mit p/n-Übergang darin, daß der Wirkungsgrad bei abnehmender Lichtintensität nicht sinkt. Gleiches gilt auch in Bezug auf den Einfall diffusen Lichtes, denn auch hier sinkt der Wirkungsgrad im Unterschied zu herkömmlichen Solarzellen nicht.

Gebildet ist die elektrolytische Schicht erfindungsgemäß durch einen Festkörperelektrolyten. Im Unterschied zu flüssigen oder gelartigen Elektrolytschichten bedarf es bei der Verwendung eines Festkörperelektrolyten nicht einer zusätzlichen Abdichtung der elektrolytischen Schicht gegenüber den anderen Schichten der Solarzelle. Erreicht wird auf diese Weise eine vereinfachte und im Vergleich zu herkömmlichen Solarzellen kostengünstige Herstellung. Auch treten Abdichtungsprobleme, wie dies bei der aus dem Stand der Technik bekannten Verwendung von flüssigen Elektrolyten der Fall ist, nicht auf. Damit verfügt die erfindungsgemäße Solarzelle im Vergleich zu den aus dem Stand der Technik bekannten Solarzellen über eine wesentlich verbesserte Betriebssicherheit. Hierdurch bedingt können Kontroll- und Wartungsarbeiten in vorteilhafter Weise auf ein Minimum reduziert werden. Von Vorteil ist des weiteren, daß ein Festkörperelektrolyt gegenüber herkömmlichen Elektrolytschichten eine gesteigerte lonenleitfähigkeit aufweist, was den Wirkungsgrad der gesamten Solarzelle erhöht.

Gemäß einem ersten Vorschlag der Erfindung ist die vorzugsweise aus einem transparenten, semi-transparenten oder opaken Material gebildete photoempfindliche Schicht mittels Kolloidfärbung physikalisch gefärbt. Eine chemische Einfärbung der photoempfindlichen Schicht erfolgt gemäß dieser Ausführungsform nicht. Statt dessen ist die Elektronenzahl auf der Atombahn des die photoempfindliche Schicht bildenden Materials auf die Reflexion der Schicht im gewünschten Wellenbereich abgestimmt.

Von besonderem Vorteil dieser erfindungsgemäßen Weiterentwicklung ist, daß auf den Einsatz von Sensibilisatorfarbstoffen verzichtet werden kann. Zum einen können hierdurch die Herstellungskosten gesenkt werden, zum anderen ergibt sich in vorteilhafter Weise eine gegenüber herkömmlichen Solarzellen verbesserte Langzeitstabilität.

Die photoempfindliche Schicht arbeitet in vorteilhafter Weise auch im UV-Bereich. Je nach Veränderung des die photoempfindliche Schicht bildenden Materials können andere Wellenlängenbereiche in einem breiten Spektrum genutzt werden. Darüber hinaus kommt es infolge der Kolloidfärbung der photoempfindlichen Schicht zu Interferenzen, wodurch ein erweiterter Wellenbereich durch die photoempfindliche Schicht absorbiert werden kann.

Gemäß einem alternativen Vorschlag der Erfindung kann die photoempfindliche Schicht mittels Zugabe von Sensibilisatorfarbstoffen eingefärbt werden. Die Lichtabsorption der photoempfindlichen Schicht wird dann durch die Sensibilisatorfarbstoffe, wie z. B. Rutheniumkomplexe, bewerkstelligt.

Gemäß einem besonderen Vorschlag der Erfindung beinhaltet die elektrolytische Schicht anorganische oder organische Farbstoffe. In Ergänzung zur photoempfindlichen Schicht kann so eine elektrolytische Schicht ausgebildet werden, die in einem von der photoempfindlichen Schicht nicht abgedeckten Wellenlängenbereich arbeitet. Auch können die photoempfindliche Schicht und die elektrolytische in sich zum Teil überdeckenden Wellenlängenbereiche arbeiten. In Summe wird so durch die photoempfindliche Schicht einerseits und die elektrolytische Schicht andererseits ein im Vergleich zu herkömmlichen Solarzellen vergrößerter Wellenlängenbereiche abgedeckt, was in vorteilhafter Weise den Wirkungsgrad der erfindungsgemäßen Solarzelle erhöht. So kann beispielsweise vorgesehen sein, daß die photoempfindliche Schicht auch im UV-Bereich, die elektrolytische Schicht im sichtbaren Wellenlängenbereich arbeitet.

Von besonderem Vorteil der erfindungsgemäßen Solarzelle ist ihre Wirtschaftlichkeit. Dies wird zum einen dadurch bedingt, daß der Herstellungsprozeß vereinfacht und mithin auch kostengünstiger durchgeführt werden kann. So ist es beispielsweise im Unterschied zu herkömmlichen Silicium-Solarzellen nicht erforderlich, den Solarzellen-Herstellungsprozeß unter Reinraumbedingungen durchzuführen. Die einzelnen Schichten der Solarzelle können vielmehr unter atmosphärischen Bedingungen unmittelbar aufeinanderfolgend auf eine Trägerschicht aufgebracht werden. Dabei können in Abhängigkeit des späteren Verwendungszwecks der Solarzelle als Trägerschicht sowohl flexible Medien, wie beispielsweise Dachbahnen, Membranen oder Textilstoffe, aber auch starre Medien, wie beispielsweise Glas- oder Metallkörper Verwendung finden. Von weiterem Vorteil der erfindungsgemäßen Solarzelle ist der gegenüber herkömmlichen Solarzellen gesteigerte Wirkungsgrad sowie die verbesserte Langzeitbeständigkeit, was einen effektiveren Einsatz der erfindungsgemäßen Solarzelle gegenüber herkömmlichen Solarzellen ermöglicht. Zudem ist insbesondere die Verwendung eines Festkörperelektrolyten von Vorteil, denn ist es nicht erforderlich, diesen gegenüber den anderen Schichten der Solarzelle abzudichten, wie dies bei der Verwendung eines flüssigen Elektrolyten der Fall ist. Abdichtungsprobleme können so von vornherein in vorteilhafter Weise ausgeschlossen werden. Erhöht werden kann hierdurch nicht nur die Betriebssicherheit der Solarzelle, auch können Kontroll- und Wartungsarbeiten auf ein Minimum reduziert werden. Zudem ist die Herstellung einer einen Festkörperelektrolyten aufweisenden Solarzelle vergleichsweise weniger aufwendig und damit kostengünstiger.

Vorgeschlagen wird mit der Erfindung des weiteren ein photoelektrochemisches Modul. Gebildet ist das photoelektrochemische Modul aus einer beliebigen Vielzahl von photoelektrochemischen Solarzellen des vorbeschriebenen Typs, die bevorzugterweise in Serie geschaltet sind. Je nach Anzahl der verwendeten elektrochemischen Solarzellen kann so ein nahezu beliebiger Wert an nutzbarer Spannung erzeugt werden.

Da es der Aufbau der elektrochemischen Solarzelle erlaubt, eine nahezu beliebige Oberflächengröße anzunehmen, können bevorzugterweise elektrochemische Solarzellen mit unterschiedlichen geometrischen Abmessungen nach dem Baukastenprinzip miteinander zu einem Modul kombiniert werden. Auf diese Weise können photoelektrochemische Module ausgebildet werden, die bedarfsgerecht an unterschiedlich geometrische Gegebenheiten angepaßt werden können.

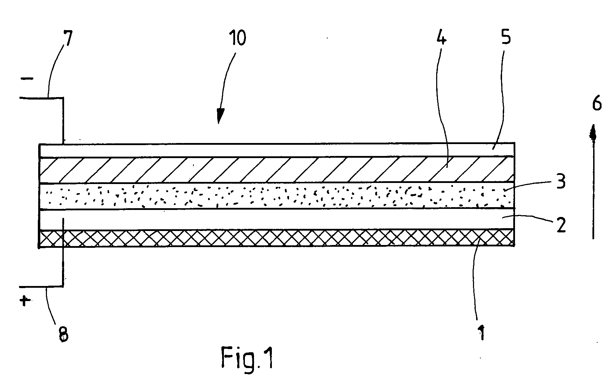

Weitere Vorteile und Merkmale der Erfindung ergeben sich aus der Beschreibung anhand der nachfolgenden Fig. 1.

Dargestellt in Fig. 1 ist in schematischer Seitenansicht der Schichtaufbau der erfindungsgemäßen Solarzelle 10.

Als Basissubstrat für die Solarzelle 10 dient ein Trägerstoff 1 aus einem gemäß diesem Ausführungsbeispiel flexiblen Material, beispielsweise eine Textilstoffbahn oder eine Dachbahn, beispielsweise eine PVC-Dachmembran. Direkt auf diesen Trägerstoff 1 aufgebracht ist in Form einer positiven Elektrode eine elektronenleitende Schicht 2. Diese elektronenleitende Schicht kann aus folgenden Materialien bestehen:
- eine im Sol-Gel-Verfahren hergestellte Schicht, die Elektronenleiter beinhaltet
- eine im Sol-Gel-Verfahren hergestellte Schicht, die leitfähige Oxide beinhaltet
- eine polymere Schicht, die cross-linked Elektronenleiter beinhaltet
- eine polymere Schicht, die cross-linked leitfähige Oxide beinhaltet
- eine polymere Schicht, die rein aus elektronenleitfähigen Polymeren besteht
- ein Monomer, welches durch Zuschlagstoff(e) erst nach der Applikation polymerisiert und elektrisch leitfähig ist
- ein Polymer auf der Basis 3,4-Polyethylendioxythiophen.

Darüber hinaus kann die elektronenleitende Schicht 2 mit einem Katalysator, wie beispielsweise Graphit oder anderen Kohlenstoffverbindungen versehen sein. Auch können Stoffe der VIII. Nebengruppe als Katalysator dienen.

Die elektronenleitende Schicht 2 kann transparent, semi-transparent oder opak ausgeführt sein.

Gemäß einer bevorzugten Ausführungsform wird die die positive Elektrode bildende elektronenleitende Schicht 2 wie folgt hergestellt:

Zunächst werden Pd(ac)₂ bzw. Pd(NO₃)₂ in Aceton gelöst. Hierzu wird ein Gemisch aus DIAMO und 2 - 15 ml Ethanol zugegeben. Das molare Verhältnis kann zwischen 3 : 1 und 16 : 1 variiert werden. Dieser Mischung werden dann 0 - 100 ml Grundsol zugegeben. (Je nach gewünschter Pd Konzentration.) Nachdem das Lösungsmittel bei vorzugsweise 30 Grad Celsius im Wasserstrahlvakuum mit der Membranpumpe abdestilliert wurde, kann das Sol sofort zur Weiterverarbeitung verwendet werden.

Dieses so erhaltene Sol wird der Rezeptur zur Herstellung der Minus-Elektrode (wie im weiteren noch beschrieben werden wird) zugegeben und ist beschichtungsfertig.

Als zweite Schicht ist eine elektrolytische Schicht 3 vorgesehen, die direkt auf die elektronenleitende Schicht 2 aufgetragen ist. Erfindungsgemäß ist die elektrolytische Schicht 3 durch einen Festkörperelektrolyten gebildet.

Der Wellenlängenbereich, in dem die elektrolytische Schicht 3 arbeitet, kann durch Zugabe von organischen oder anorganischen Farbstoffen gezielt eingestellt werden. Bevorzugterweise arbeitet die elektrolytische Schicht im Bereich des sichtbaren Lichtes.

Die elektrolytische Schicht 3 kann gleichfalls transparent, semi-transparent oder opak ausgebildet sein.

Gemäß einer bevorzugten Ausführungsform wird die elektrolytische Schicht 3 gemäß nachfolgender Rezeptur hergestellt:
Polyol
Isocyanat
Propylencarbonat
Li-Triflat.

Das Material ist beschichtungsfertig und kann unter Temperaturzufuhr in der Trocknung beschleunigt werden.

In Höhenrichtung 6 der Solarzelle 10 folgt eine weitere Schicht, nämlich die photoempfindliche Schicht 4. Die photoempfindliche Schicht 4 besteht aus einem transparenten, semi-transparenten oder opaken Material, wobei die Elektronenanzahl auf der Atombahn des die photoempfindliche Schicht 4 bildenden Materials auf die Reflexion der Schicht 4 im gewünschten Wellenbereich abgestimmt ist. Dabei arbeitet die photoempfindliche Schicht 4 vorzugsweise im UV-Bereich als auch im sichtbaren Wellenlängenbereich, so daß in Überdeckung mit der elektrolytischen Schicht 3 ein breites Wellenlängenspektrum durch die Solarzelle 10 abgedeckt ist.

Die photoempfindliche Schicht 4 kann aus folgenden Materialien bestehen:
- eine im Sol-Gel-Verfahren hergestellte Schicht, die Stoffe der IV. Nebengruppe beinhaltet
- eine im Sol-Gel-Verfahren hergestellte Schicht, die Stoffe der IV. Hauptgruppe und Stoffe der V. Hauptgruppe sowie Stoffe der III. Hauptgruppe beinhaltet
- eine im Sol-Gel-Verfahren hergestellte Schicht, die Stoffe der I. Nebengruppe und Stoffe der III. Hauptgruppe beinhaltet
- eine im Sol-Gel-Verfahren hergestellte Schicht, die Stoffe der VI. Hauptgruppe und Stoffe der II. Nebengruppe beinhaltet
- eine polymere Schicht, die cross-linked Stoffe der IV. Nebengruppe beinhaltet
- eine polymere Schicht, die cross-linked Stoffe der IV. Hauptgruppe und Stoffe der V. Hauptgruppe sowie Stoffe der III. Hauptgruppe beinhaltet
- eine polymere Schicht, die cross-linked Stoffe der I. Nebengruppe und Stoffe der III. Hauptgruppe beinhaltet
- eine polymere Schicht, die cross-linked Stoffe der VI. Hauptgruppe und Stoffe der II. Nebengruppe beinhaltet.

Gemäß einer bevorzugten Ausführungsform wird die photoempfindliche Schicht 4 wie folgt hergestellt:
a) Herstellung eines hochbrechenden Sols
   20 - 140 g, vorzugsweise 70 - 100 g TiO₂ Sol (3,5 Gew.-% TiO₂ in Isopropanol; Teilchengröße unter vorzugsweise 5 nm) werden mit 1,0 - 2,5, vorzugsweise 1,7 - 2,3 g Phosphorsäuretriburylester versetzt und gerührt. Das Sol wird anschließend bei 100 Grad Celsius tropfenweise mit einer Lösung von 0,8 - 1,6, vorzugsweise 1,0 - 1,4 g destilliertem 3-Glicidyloxipropyltrimethoxysilan (GPTS) in 100 g Isopropoxyethanol versetzt. Nach Rühren wird der Ansatz abgekühlt und es werden 0,6 - 1,2, vorzugsweise 0,8 - 1,0 g GPTS (hergestellt durch Versetzen von GPTS mit NHCL und Rühren sowie anschließendem Abdestillieren von niedermolekularen Reaktionsprodukten bei 3 mbar) zugegeben. Nach weiterem Rühren wird der Ansatz unter Vakuum (3 mbar) destilliert und anschließend mit Isopropoxyethanol verdünnt. Somit wird ein agglomeratfreies Sol erhalten.
b) Herstellung eines Grundsols
   Zur Solsynthese werden 160 g 3-Glicidyloxipropyltrimethoxysilan (GPTS) und 20 - 60 g, vorzugsweise 30 - 50 g Tetraethoxysilan (TEOS) mit 120 ml Ethanol vermischt und unter Rühren erhitzt. (Molverhältnis 80 : 20). Dieser Mischung werden 20 - 40 g, vorzugsweise 25 - 35 g Wasser und HNO₃ konz. zugegeben und 15 h bei 60 Grad Celsius gerührt. Das so erhaltene Sol wird mit Ethanol verdünnt und kann mehrere Wochen als Beschichtungssol eingesetzt werden.
c) Herstellung des goldkolloidhaltigen Sols
   0,20 - 0,40 g, vorzugsweise 0,25 - 0,35 g H(Au CL₄) -2H₂O werden in 4 ml Ethanol gelöst. Zu dieser Lösung werden 0,05 - 0,50 g, vorzugsweise 0,10 - 0,20 g DIAMO in 1 ml Ethanol gelöst, zugetropft. Das auf diese Weise vorkomplexierte Gold wird dann zu 20 ml vorhydrolisiertem GPTS/TEOS Grundsol, in das zuvor 1,0 - 2,5 ml, vorzugsweise 1,2 - 1,9 ml DIAMO eingerührt wurde, zugetropft. Auf diese Weise kann jedes beliebige Gold-Stabilisatorverhältnis (Molares Verhältnis von Au zu Stabilisator bis 1 : 30) erreicht werden. Die komplexe Mischung wird 30 min. gerührt und durch 1,2 und 0,8 µm Filter filtriert.

Das hochbrechende Sol wird dem goldkolloidhaltigem Sol vermischt und ist beschichtungsfähig. Das Gold wird nach der Beschichtung zwischen 80 und 120 Grad Celsius durch Ethanol zum Kolloid reduziert.

Je nach Mischungsverhältnis und Kolloidgröße erhält man rot, violett oder blauviolett.

Gemäß dem Ausführungsbeispiel nach Fig. 1 ist in Höhenrichtung 6 oberhalb der photoempfindlichen Schicht 4 eine weitere elektronenleitende Schicht 5 angeordnet, die gemäß dem hier gezeigten Ausführungsbeispiel als Minuselektrode geschaltet ist. Die elektronenleitende Schicht 5 kann in vorteilhafter Weise direkt auf die photoempfindliche Schicht 4 aufgetragen werden.

Gemäß einer bevorzugten Ausführungsform wird die die Minus-Elektrode bildende elektronenleitende Schicht 4 wie folgt hergestellt:

Die Minus-Elektrode, bestehend aus leitfähigem Polymer 3, 4-Polyethylendioxythiophen (PEDT). PEDT Beschichtungsmaterial ist begrenzt mischbar mit wassermischbaren Lösemitteln wie z. B. Ethanol, Isopropanol oder Aceton. Durch den Zusatz von Lösemitteln erhält man eine bessere Benetzung der Substrate und eine raschere Trocknung der Beschichtung. Anteile an hochsiedenden Lösemitteln wie N-Mthylpyrrolidon (NMP) oder Ethylenglycol verbessern außerdem die Filmbildung und erhöhen die elektrische Leitfähigkeit der Beschichtungen. Zur Erzielung haftfester Beschichtungen auf Kunststoffen können der Dispersion organische Bindemittel hinzugesetzt werden. Geeignet sind wässrige Polyurethandispersionen, Polyvinylidenchloridlacties, Polymethylmethacrylatrices, Polivinylacetate, Polyvinylalkohole oder Polyvinylpyrrolidone.

Unter dem Zusatz von Dimethylethaolamin werden Unverträglichkeiten zwischen dem leitfähigem Polymer und dem Bindemittel aufgehoben werden.

Organofunktionelle Silane wie z.B. y-Glycidoxpropyltrimethoxysilan erhöhen Haftung und Wasserfestigkeit der PEDT Beschichtung. Die Kratzfestigkeit kann durch Zugabe von Alkoxysilanen wie z.B. Tetraethoxysilan deutlich verbessert werden.

Die leitfähige Beschichtung kann auch durch direkte Polymerisation des Monomers auf die Substratoberfläche aufgebracht werden. Hierzu wird zunächst das Grundmonomer mit Lösemitteln wie z.B. Butanol, Isopropanol, Methanol oder Aceton verdünnt werden. Zur Verbesserung der Haftung können Epoxisilane zugesetzt werden. Nach Beschichtung mit der flüssigen Mischung und Verdunsten der Lösemittel bildet sich das leitfähige Polymer PEDT.

Folgende Richtrezeptur wird verwendet:

| Stoff | Gew.-% |
|---|---|
| PEDT | 30 - 60, vorzugsweise 40 - 50 |
| N-Methyl-2-pyrrolidon | 1 - 4, vorzugsweise 2 - 3 |
| Gamma-Glycidpropyl-trimethoxysilan | 0,05 -1,8, vorzugsweise 0,7 - 1,0 |
| Isopropanol | 30 - 80, vorzugsweise 45 - 65 |
| Bayowet FT 219 | 0,1 - 0,5, vorzugsweise 0,2 - 0,4 |

Alle Komponenten müssen in der oben aufgeführten Reihenfolge unter ständigem Rühren vermischt werden.

Dieses elektrisch leitfähige Polymer ist flexibel und transparent. Es beinhaltet weder Nanopartikel noch metallische Oxide.

Die aus Trägerstoff 1, elektronenleitender Schicht 2, elektrolytischer Schicht 3, photoempfindlicher Schicht 4 und elektronenleitender Schicht 5 gebildete Solarzelle 10 ist auf wirtschaftliche Weise herstellbar und verfügt in vorteilhafter Weise über einen Wirkungsgrad von bis zu 30 %. Die Solarzelle 10 ist damit im Vergleich zu herkömmlichen Solarzellen von weitaus größerer Effektivität, denn besitzen die aus dem Stand der Technik bekannten Solarzellen zumeist nur einen Wirkungsgrad von bis zu ca. 15 %.

Für ein Abgreifen des von der Solarzelle 10 erzeugten Stroms kann diese mittels elektrischer Leitungen, die in der Fig. 1 schematisch dargestellt mit 7 und 8 bezeichnet sind, in einen Stromkreislauf eingeschaltet werden.

### Bezugszeichenliste

- 1: Trägerstoff
- 2: elektronenleitende Schicht
- 3: elektrolytische Schicht
- 4: photoempfindliche Schicht
- 5: elektronenleitende Schicht
- 6: Höhenrichtung
- 7: elektrische Leitung
- 8: elektrische Leitung
- 10: Solarzelle

## Patentansprüche

1. Photoelektrochemische Solarzelle, aufweisend eine erste elektronenleitende Schicht (5) und eine zweite elektronenleitende Schicht (2), eine zwischen der ersten und der zweiten elektronenleitenden Schicht (2, 5) angeordnete photoempfindliche Schicht (4) sowie eine zwischen photoempfindlicher und zweiter elektronenleitenden Schicht (4, 2) angeordnete elektrolytische Schicht (3), wobei die elektrolytische Schicht (3) durch einen Festkörperelektrolyten gebildet ist.

2. Solarzelle nach Anspruch 1, **dadurch gekennzeichnet, daß** die photoempfindliche Schicht (4) transparent, semi-transparent oder opak ausgebildet ist.

3. Solarzelle nach einem der Ansprüche 1 oder 2, **dadurch gekennzeichnet, daß** die photoempfindliche Schicht (4) mittels Kolloidfärbung physikalisch eingefärbt ist.

4. Solarzelle nach Anspruch 3, **dadurch gekennzeichnet, daß** die Elektronenzahl auf der Atombahn des die photoempfindliche Schicht (4) bildenden Materials auf die Reflexion der Schicht (4) im gewünschten Wellenbereich abgestimmt ist.

5. Solarzelle nach einem der Ansprüche 1 bis 4, **dadurch gekennzeichnet, daß** die photoempfindliche Schicht (4) eine polymere Schicht ist.

6. Solarzelle nach einem der vorhergehenden Ansprüche, **dadurch gekennzeichnet, daß** die elektrolytische Schicht (3) Farbstoffe beinhaltet.

7. Solarzelle nach einem der vorhergehenden Ansprüche, **dadurch gekennzeichnet, daß** die erste elektronenleitende Schicht (5) als negative Elektrode und die zweite elektronenleitende Schicht (2) als positive Elektrode geschaltet sind.

8. Solarzelle nach einem der vorhergehenden Ansprüche, **dadurch gekennzeichnet, daß** die einzelnen Schichten in Höhenrichtung (6) unmittelbar aufeinanderfolgend ausgebildet sind.

9. Photoelektrochemisches Modul, umfassend eine Vielzahl photoelektrochemischer Solarzellen (10) nach einem der Ansprüche 1 bis 9.

## Geänderte Patentansprüche

### Geänderte Patentansprüche gemäss Regel 86(2) EPÜ.

**1.** Photoelektrochemische Solarzelle, aufweisend eine erste elektronenleitende Schicht (5) und eine zweite elektronenleitende Schicht (2), eine zwischen der ersten und der zweiten elektronenleitenden Schicht (2, 5) angeordnete photoempfindliche Schicht (4) sowie eine zwischen photoempfindlicher und zweiter elektronenleitender Schicht (4, 2) angeordnete elektrolytische Schicht (3), wobei die elektrolytische Schicht (3) durch einen Festkörperelektrolyten gebildet ist, und wobei die photoempfindliche Schicht (4) mittels Kolloidfärbung physikalisch eingefärbt ist.

**2.** Solarzelle nach Anspruch 1, **dadurch gekennzeichnet, daß** die photoempfindliche Schicht (4) transparent, semi-transparent oder opak ausgebildet ist.

**3.** Solarzelle nach Anspruch 1 oder 2, **dadurch gekennzeichnet, daß** die Elektronenzahl auf der Atombahn des die photoempfindliche Schicht (4) bildenden Materials auf die Reflexion der Schicht (4) im gewünschten Wellenbereich abgestimmt ist.

**4.** Solarzelle nach einem der Ansprüche 1 bis 3, **dadurch gekennzeichnet, daß** die photoempfindliche Schicht (4) eine polymere Schicht ist.

**5.** Solarzelle nach einem der vorhergehenden Ansprüche, **dadurch gekennzeichnet, daß** die elektrolytische Schicht (3) Farbstoffe beinhaltet.

**6.** Solarzelle nach einem der vorhergehenden Ansprüche, **dadurch gekennzeichnet, daß** die erste elektronenleitende Schicht (5) als negative Elektrode und die zweite elektronenleitende Schicht (2) als positive Elektrode geschaltet sind.

**7.** Solarzelle nach einem der vorhergehenden Ansprüche, **dadurch gekennzeichnet, daß** die einzelnen Schichten in Höhenrichtung (6) unmittelbar aufeinanderfolgend ausgebildet sind.

**8.** Photoelektrochemisches Modul, umfassend eine Vielzahl photoelektrochemischer Solarzellen (10) nach einem der Ansprüche 1 bis 7.
